# DEMANDE DE BREVET EUROPEEN

(11) **EP 2 719 718 A1**
(43) Date de publication de la demande: **16.04.2014**
(21) Numéro de dépôt: 14150892.9
(22) Date de dépôt: 04.08.2010
(51) Int. Cl.: C08J 5/22, C08K 3/22, H01L 31/00, C08J 3/22, C08L 27/16

(54) **Film a base de polymere fluore et de pmma pour application photovoltaïque et son procédé de fabrication**

(30) Priorité: 05.08.2009 FR 0955515
(62) Demande divisionnaire de: 10762967.7
(71) Demandeur: ARKEMA FRANCE, 92700 Colombes (FR)
(72) Inventeur: Bonnet, Anthony, 69720 SAINT-LAURENT-DE-MURE (FR); Beaume, François, 69230 SAINT GENIS LAVAL (FR); Devaux, Nicolas, 69003 LYON (FR); Triballier, Karine, 44750 CAMPBON (FR); Bizet, Stéphane, 27170 BARC (FR); Godefroy, Frédéric, 76480 MESNIL SOUS JUMIEGES (FR)
(74) Mandataire: Albani, Dalila

(57) **Abrégé**

La présente invention concerne un procédé de préparation d'une composition comprenant un polymère ou copolymère de fluorure de vinylidène (PVDF) et au moins une charge inorganique, ledit procédé comprenant les étapes suivantes :
i) préparer un mélange maître acrylique en dispersant ladite charge inorganique dans un polymère ou copolymère de méthacrylate de méthyle (PMMA), et
ii) mélanger ledit mélange maître avec le PVDF à l'état fondu.

L'invention vise également un film monocouche opaque aux radiations UV et transparent dans le domaine visible, consistant en la composition ainsi préparée. Enfin, l'invention a trait aux panneaux photovoltaïques dans lesquels la face avant et/ou la face arrière sont constituées dudit film.

## Description

La présente invention concerne une composition comprenant un polymère fluoré et de l'oxyde de zinc de taille nanométrique. L'invention se rapporte également aux films fabriqués à partir de ladite composition. Du fait de leur transparence dans le domaine visible et opacité aux radiations UV, ces films sont notamment destinés à une utilisation comme face avant dans une cellule photovoltaïque.

Une cellule photovoltaïque est constituée d'un matériau semi-conducteur pris en sandwich entre deux électrodes métalliques, le tout étant protégé par une face avant (« frontsheet ») et une face arrière (« backsheet »). La face avant d'une cellule photovoltaïque doit principalement protéger les éléments de la cellule de toute agression mécanique. Elle doit également prévenir des effets dus au vieillissement induit notamment par les radiations UV et l'oxygène. Afin d'utiliser le plus efficacement possible la lumière solaire, la face avant d'une cellule photovoltaïque doit bien entendu avoir une transmittance élevée dans un certain domaine spectral, qui par exemple s'étend de 400 à 1100 nm pour une cellule à base de Silicium cristallin.

Il est connu de fabriquer des cellules photovoltaïques avec une face avant en verre, matériau à coût faible et très répandu, qui présente en outre une résistance mécanique élevée. Une face avant en verre présente toutefois plusieurs inconvénients : une transmittance plafonnée à 92% dans la gamme allant de 400 à 1100 nm, un poids élevé, une résistance au choc faible, nécessitant des soins particuliers pendant le transport, l'installation et l'utilisation des cellules photovoltaïques.

Des faces avant en matériaux plastiques pallient à plusieurs de ces inconvénients. En effet, il existe des matériaux plastiques présentant une transmittance supérieure à celle du verre, plus légers et possédant une résistance au choc satisfaisante.

Ainsi, il est connu d'utiliser des polymères fluorés en général et notamment du PVDF (polyfluorure de vinylidène difluoride VDF) pour fabriquer des films destinés à protéger les objets et matériaux, en raison de leur très bonne résistance aux intempéries, au rayonnement UV et à la lumière visible, et aux produits chimiques. Ces films présentent une très bonne résistance thermique pour des applications extérieures soumises à des conditions climatiques sévères (pluie, froid, chaud) ou des procédés de transformation réalisés à haute température (>130°C).

Des films monocouche à base de polymères fluorés (copolymère d'éthylène et tétrafluoroéthylène ou ETFE ; PVDF ; copolymère d'éthylène et de propylène ou FEP, etc), commercialisés par des sociétés comme DuPont, Asahi Glass, Saint-Gobain, Rowland Technologies, sont déjà utilisés comme face avant pour cellules photovoltaïques.

Généralement, pour protéger un film polymère contre la dégradation par des rayons UV, des absorbeurs UV organiques et/ou des charges minérales y sont incorporées. Il est connu que l'ajout de charges inorganiques de type TiO₂, SiO₂, CaO, MgO, CaCO₃, Al₂O₃ et bien d'autres encore dans une polymère fluoré, tel qu'un polymère ou copolymère de fluorure de vinylidène, peut entraîner une dégradation assez violente avec production d'HF (hydrure de fluoré) lorsque le mélange est réalisé à l'état fondu à haute température pour disperser la charge. Une voie pour mettre en oeuvre ces charges avec par exemple le PVDF consiste à introduire ces charges inorganiques en utilisant un mélange maître acrylique. A cet effet, les charges inorganiques sont dispersées dans un polymère ou copolymère de méthacrylate de méthyle (PMMA), puis ce mélange maître est mélangé avec le PVDF à l'état fondu. La présence d'un PMMA génère des inconvénients comme une limitation de la stabilité dimensionnelle du film obtenu en température, une résistance thermique inférieure, une odeur caractéristique de l'acrylique pendant l'assemblage des cellules et une stabilité aux UV inférieure en comparaison avec un PVDF pur. Un tel film comprenant une composition tripartite polymère fluoré/polymère acrylique/charge minérale est par exemple décrit dans le document WO 2009/101343.

Les absorbeurs d'UV organiques sont des matériaux inertes qui absorbent et diffusent les rayonnements UV. Leur utilisation est toutefois limitée en raison de leurs inconvénients, à savoir une couverture spectrale limitée, leur dégradation au cours du vieillissement et leur migration accompagnée d'un phénomène d'exsudation. Une solution, consistant à limiter la teneur en absorbeur UV, a par exemple été proposée par la Demanderesse dans le document EP 1 382 640, qui décrit des films transparents à la lumière visible et opaques aux rayonnements UV, lesdits films étant constitués de deux couches dont une comprenant du PVDF, du PMMA, un élastomère acrylique et un absorbeur UV. Les résultats exposés dans les exemples 1 à 5 montrent qu'aucune exsudation n'est observée lorsqu'un film de 15 µm d'épaisseur est gardé 7 jours dans une étuve. La limitation de la teneur en absorbeur UV ne peut toutefois convenir à la fabrication de films destinés à des durées d'utilisation plus longues, comme c'est le cas pour les cellules photovoltaïques.

Il serait donc souhaitable de disposer d'une composition exempte d'acrylique et d'absorbeur UV organique qui permet la fabrication d'un film présentant de bonnes propriétés de transparence dans le domaine visible, d'opacité aux rayonnements UV ainsi qu'une bonne résistance mécanique et au vieillissement.

Les études menées par la Demanderesse ont montré qu'il est possible de fabriquer un film présentant ces propriétés à partir d'une composition à base de polymères fluorés et d'une charge inorganique bien dispersée dans lesdits polymères fluorés toute en évitant la dégradation desdits polymères fluorés et sans ajout d'un autre constituant tel un acrylique.

A cet effet, et selon un premier aspect, l'invention concerne une composition polymérique consistant en un polymère fluoré et de l'oxyde de zinc (ZnO), ladite charge étant présente dans ladite composition dans une proportion massique de 0,1 à 10%, de préférence de 0,5 à 6%.

Avantageusement, le polymère fluoré est un homopolymère de vinylidène difluorure ou un copolymère de vinylidène difluorure et au moins un autre monomère fluoré.

De manière caractéristique, les particules de ZnO incorporées dans la composition ont une taille allant de 25 à 40 nm, de préférence de 30 à 35 nm. Cette taille nanométrique particulière permet une bonne dispersion des particules dans la masse de polymère sans initier la dégradation de ce dernier lorsqu'il est à l'état fondu au cours des étapes de compoundage et de transformation. Avantageusement, la surface des particules de ZnO est rendue chimiquement inerte grâce à un traitement de surface ; ceci augmente la compatibilité avec le polymère fluoré et conduit à l'obtention d'une suspension homogène et stable dans le temps. En outre, la composition selon l'invention est exempte de polymères acryliques, ce qui élimine le risque de production d'odeurs désagréables lors de la transformation.

Selon un deuxième aspect, l'invention concerne un film monocouche obtenu à partir de la composition précitée, ledit film étant opaque aux radiations UV et transparent dans le domaine visible et présentant une stabilité à long terme. Ces propriétés le recommandent tout particulièrement pour une utilisation comme face avant ou « frontsheet » dans une cellule photovoltaïque. Le film selon l'invention peut toutefois se prêter à une utilisation comme face arrière ou « backsheet » dans une cellule photovoltaïque.

L'invention a trait aussi à un procédé de fabrication de la composition précitée, comprenant une étape d'incorporation par voie fondue de ladite charge dans le polymère fluoré.

En outre, l'invention se rapporte également à un procédé de fabrication du film selon l'invention, comprenant une étape d'extrusion-soufflage à une température comprise entre 220°C et 240°C, à un débit de 300 kg/heure.

L'invention et les avantages qu'elle procure seront mieux compris à la lumière de la description détaillée qui va suivre et des figures annexées dans lesquelles :
- la figure 1 est un diagramme représentant la variation de l'absorbance à 340 nm du film selon l'invention en fonction du taux massique de ZnO dans la composition ;
- la figure 2 est un diagramme représentant la variation de la transmittance à 450 nm du film selon l'invention en fonction du taux massique de ZnO dans la composition ;

Les recherches menées par la Demanderesse, visant à améliorer les films à base de polymères fluorés, transparents dans le domaine visible et opaques aux rayonnements UV, connus, l'ont conduite à la mise au point de compositions à base de polymère fluorés comprenant comme charge inorganique des particules de ZnO d'une taille nanométrique particulière, qui, à l'état dispersé et en l'absence d'un autre constituant tel un absorbeur d'UV organique ou un polymère acrylique, sont aptes à assurer de bonnes propriétés de transparence dans le domaine visible et d'opacité UV d'un film fabriqué à partir de ladite composition, sans initier la dégradation desdits polymères fluorés au cours des étapes de compoundage et de transformation.

Un premier objet de l'invention est donc une composition polymérique consistant en un polymère fluoré et de l'oxyde de zinc, ladite charge étant présente dans ladite composition dans une proportion massique de 0,1 à 10%, de préférence de 0,5 à 6%, caractérisée en ce que :
- le polymère fluoré est un homopolymère de vinylidène difluorure ou un copolymère de vinylidène difluorure et au moins un autre monomère fluoré,
- les particules de ZnO ont une taille allant de 25 à 40 nm, de préférence de 30 à 35 nm,
- qu'elles possèdent un traitement de surface, qui les rend chimiquement inertes,
- et en ce que ladite composition est exempte de polymères acryliques.

Le polymère fluoré entrant dans la composition selon l'invention est préparé par polymérisation d'un ou plusieurs monomère(s) de formule (I) : 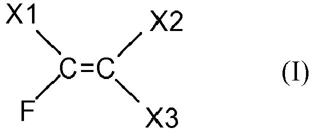 dans laquelle :
- X₁ désigne H ou F ;
- X₂ et X₃ désignent H, F, Cl, un groupement alkylé fluoré de formule CₙFₘHₚ- ou un groupement alcoxy fluoré CₙFₘHₚO-, n étant un entier compris entre 1 et 10, m un entier compris entre 1 et (2n+1), p valant 2n+1-m.

Comme exemples de monomères, on peut citer l'hexafluoropropylène (HFP), le tétrafluoroéthylène (TFE), le fluorure de vinylidène (VDF, CH₂=CF₂), le chlorotrifluoroéthylène (CTFE), les éthers vinyliques perfluoroalkyle tels que CF₃-O-CF=CF₂, CF₃-CF₂-O-CF=CF₂ ou CF₃-CF₂CF₂-O-CF=CF₂, le 1-hydropentafluoropropène, le 2-hydro-pentafluoropropène, le dichlorodifluoroéthylène, le trifluoroéthylène (VF₃), le 1,1-dichlorofluoroéthylène et leurs mélanges, les dioléfines contenant du fluor, par exemple les dioléfines telles que l'éther perfluorodiallyle et le perfluoro-1,3-butadiène.

Le polymère fluoré est un homopolymère ou un copolymère de VDF.

Avantageusement, le comonomère fluoré copolymérisable avec le VDF est choisi par exemple parmi le fluorure de vinyle; le trifluoroéthylène (VF3); le chlorotrifluoroethylène (CTFE); le 1,2-difluoroéthylène; le tetrafluoroéthylène (TFE); l'hexafluoropropylène (HFP); les perfluoro(alkyl vinyl) éthers tels que le perfluoro(méthyl vinyl)éther (PMVE), le perfluoro(éthyl vinyl) éther (PEVE) et le perfluoro(propyl vinyl) éther (PPVE); le perfluoro(1,3-dioxole); le perfluoro(2,2-diméthyl-1,3-dioxole) (PDD), et leur mélanges.

De préférence le comonomère fluoré est choisi parmi le chlorotrifluoroéthylène (CTFE), l'hexafluoropropylène (HFP), le trifluoroéthylène (VF3) et le tétrafluoroéthylène (TFE), et leur mélanges. Le comonomère est avantageusement l'HFP car il copolymérise bien avec le VDF et permet d'apporter de bonnes propriétés thermomécaniques. De préférence, le copolymère ne comprend que du VDF et de l'HFP.

De préférence, le polymère fluoré est un homopolymère de VDF (PVDF) ou un copolymère de VDF comme VDF-HFP contenant au moins 50% en masse de VDF, avantageusement au moins 75% en masse de VDF et de préférence au moins 90% en masse de VDF. On peut citer par exemple plus particulièrement les homopolymères ou copolymères de VDF contenant plus de 75% de VDF et le complément de HFP suivants : KYNAR^{®} 710, KYNAR^{®} 720, KYNAR^{®} 740, KYNAR FLEX^{®} 2850, KYNAR FLEX^{®} 3120, commercialisés par la société ARKEMA.

Avantageusement, le homopolymère ou un copolymère de VDF ont une viscosité allant de 100 Pa.s à 3000 Pa.s, la viscosité étant mesurée à 230°C, à un gradient de cisaillement de 100 s⁻¹ à l'aide d'un rhéomètre capillaire. En effet, ce type de polymère est bien adapté à l'extrusion. De préférence, le polymère a une viscosité allant de 500 Pa.s à 2900 Pa.s, la viscosité étant mesurée à 230°C, à un gradient de cisaillement de 100 s⁻¹ à l'aide d'un rhéomètre capillaire.

L'oxyde de zinc entrant dans la composition selon l'invention a une fonction d'opacifiant dans le domaine de l'UV (185 à 400 nm), et joue un rôle de filtre solaire de sorte qu'un film préparé à partir de la composition selon l'invention est un film opaque aux radiations UV, principalement par diffusion/réflexion des rayons UV.

La taille des particules de la charge est comprise entre 25 à 40 nm, de préférence de 30 à 35 nm (bornes comprises). La teneur massique en charge minérale dans la composition est comprise entre 0,1 et 10%, avantageusement entre 0,5 et 6% (bornes comprises). Cette teneur ainsi que la faible taille des particules assurent des bonnes propriétés de transparence dans le domaine visible (400 à 700 nm) pour un film fabriqué à partir de la composition selon l'invention.

Avantageusement, dans la composition selon l'invention, les particules de ZnO ont un traitement de surface qui rend lesdites particules hydrophobes. Ceci a comme effet de prévenir la dégradation des polymères fluorés, notamment du PVDF, au cours des étapes de compoundage et de transformation. Par « traitement de surface » des particules de ZnO on comprend dans le cadre de l'invention une opération chimique ou physique qui a pour conséquence de modifier la surface des particules de ZnO afin de rendre celles-ci chimiquement inertes vis à vis du polymère fluoré. Ceci a pour effet d'éviter un jaunissement du polymère fluoré.

Selon un mode de réalisation, les particules de ZnO sont enrobées de composés à base de silicium, tels le silane ou les composés à base de silane. Un exemple de ce type est constitué par la poudre de ZnO de la gamme commercialisée sous le nom de Zano^{®} 20 par la société UMICORE.

Selon un mode préféré de réalisation, la composition selon l'invention est constituée de PVDF et de particules de ZnO de taille allant de 30 et 35 nm, la teneur massique de la charge étant de 0,5 à 6%.

La composition selon l'invention peut être préparée par un procédé comprenant une étape d'incorporation par voie fondue de ladite charge nanométrique directement dans le polymère fluoré en l'absence de polymère acrylique. Ce mode de préparation assure une bonne dispersion des particules nanométriques de ZnO pour conférer au film qui est fabriqué à partir de ladite composition une bonne opacité aux UV, tout en conservant une bonne transparence dans le visible. L'absence de polymères acryliques dans la composition assure d'une part l'absence d'odeurs d'acrylique lors de la transformation, et d'autre part garantit les excellentes propriétés du PVDF sans PMMA en termes de tenue UV long terme, tenue aux intempéries (« wheatherability »), résistance chimique, résistance à certains solvants, tenue en température, pour le film qui sera fabriqué à partir de cette composition.

Selon un autre aspect, l'invention a pour objet un film monocouche fabriqué à partir de la composition décrite plus haut. Ce film est opaque aux rayonnements UV et transparent dans le domaine visible tout en gardant de très bonnes propriétés de stabilité dimensionnelle aux températures utilisées pour la fabrication d'une face avant ou d'une face arrière et par la suite d'un panneau photovoltaïque. Par ailleurs, le film selon l'invention présente une stabilité à long terme et peut être revêtu d'une couche d'oxyde de silice ou d'aluminium afin d'obtenir des propriétés barrières à l'humidité et à l'oxygène.

Le film selon l'invention présente les caractéristiques suivantes :
- une épaisseur comprise entre 10 et 100 µm, avantageusement entre 15 et 90 µm, préférentiellement entre 20 et 80 µm (bornes comprises) ;
- une densité comprise entre 1,79 et 1,86g/cm³ (bornes comprises) ;
- un grammage compris entre 17,9 et 186 g/m² (bornes comprises) ;
- un allongement à la rupture (en %):
   o en sens machine : compris entre 50 et 500% ;
   o en sens travers : compris entre 50 et 500% ;
- une contrainte à la rupture (en MPa) :
   o en sens machine : comprise entre 30 et 70 MPa ;
   o en sens travers : comprise entre 20 et 60 MPa ;
- une modification dimensionnelle après passage à l'étuve pendant 30 min à 150°C (en %) :
   o en sens machine : < 1 %
   o en sens travers : <1%.

Avantageusement, le film selon l'invention ne présente pas d'odeur d'acrylique.

Le film selon l'invention est fabriqué, selon un premier mode de réalisation, par extrusion soufflage de gaine (« blown film ») à une température allant de 240 à 260°C. Cette technique consiste à coextruder, généralement de bas en haut, un polymère thermoplastique à travers une filière annulaire. L'extrudat est simultanément tiré longitudinalement par un dispositif de tirage, habituellement en rouleaux, et gonflé par un volume d'air constant emprisonné entre la filière, le système de tirage et la paroi de la gaine. La gaine gonflée est refroidie généralement par un anneau de soufflage d'air en sortie de la filière.

Avantageusement, la faible taille des particules de charge inorganique présente dans la composition utilisée pour la fabrication du film, ainsi que la nature de ces charges rendent possible l'obtention du film par la technique d'extrusion-soufflage à des températures de 240-260°C sans entraîner de dégradation du polymère fluoré présent dans ladite composition. Ceci permet de garder intactes les propriétés particulières de ce polymère, à savoir sa très bonne résistance aux intempéries, au rayonnement UV et à l'oxygène.

Selon un autre mode de réalisation, le film est fabriqué en suivant les étapes ci-après :
- mélanger sur calandre du ZnO nanométrique dans le polymère fluoré fondu, à une température allant de 220 à 260°C, de préférence à 240°C ;
- presser à chaud (à une température de 220 à 230°C) ce mélange pour obtenir d'abord un film plus épais (par exemple, de 150 µm d'épaisseur), puis represser celui-ci en films plus fins d'épaisseur variable, par exemple allant de 20 et 80 µm.

Selon un autre aspect, l'invention a pour objet l'utilisation de ce film pour la fabrication de la face avant dans un panneau photovoltaïque. Avantages du film selon l'invention:
- transparence visible et opacité UV « permanente » dans PVDF grace aux nanocharges, i.e. différent des d'absorbeurs UV organiques (pas de consommation, pas de migration ou exhudation), et donc maintien des performances sur le long terme
- permet un film monocouche combinant protection UV à long terme, transparence, résistance chimique et solvants, tenue température.

Selon un autre aspect, l'invention a pour objet l'utilisation de ce film pour la fabrication de la face arrière dans un panneau photovoltaïque. A cet effet, selon un mode de réalisation, le film selon l'invention subit d'abord sur ses deux faces un traitement de surface de type Corona. Ensuite, il est laminé à chaud de chaque côté d'une feuille de PET induite au préalable d'adhésif. Une des faces du laminé ainsi obtenu est ensuite pressée sur un film de type EVA, l'autre face de ce dernier étant collée contre une plaque de verre nettoyée. Cette structure laminée est utilisable comme backsheet dans une cellule photovoltaïque. Par ailleurs, le PET peut être pigmenté par du TiO2 ou pas suivant le souhait d'avoir au final un backsheet opaque ou transparent.

D'autres caractéristiques et avantages de l'invention apparaîtront à la lecture des exemples de réalisation suivants.

### SERIE-1 : mélanges sur calandre puis pressage d'un film

Les mélanges S1-A, C, D, E sont réalisés sur calandre bicylindre à 240°C en introduisant 1 à 6% de « ZnO nanométrique avec traitement de surface » (Zano20) dans du Kynar 740 fondu. Le mélange S1-B est obtenu en préparant dans les mêmes conditions un mélange-maître à 20% de « ZnO nanométrique avec traitement de surface » (Zano20) dans du Kynar 740, lequel mélange-maître est ensuite dilué à hauteur de 5% dans du Kynar 740 pour obtenir une composition finale identique à celle du mélange S1-A. Après refroidissement, tous ces mélanges apparaissent blancs et exempts de bulles. Le Kynar 740 utilisé ici est un PVDF homopolymère.

Ils sont ensuite pressés à 220-230°C en films de 150 µm d'épaisseur, puis repressés en films plus fins d'environ 50-75 µm

Les mélanges S1-F et S1-G ont été préparés selon le même protocole que les mélanges S1-A et S1-B, respectivement, mais en utilisant du « ZnO nanométrique sans traitement de surface » et en abaissant la température à 200°C. Ces deux mélanges ainsi que le mélange-maître intermédiaire présentent des signes visibles de début de dégradation du Kynar 740 : coloration jaune/brun, voire brun prononcé pour le mélange-maitre, et présence de fines bulles. Ces caractéristiques indiquent un début de dégradation du Kynar 740 induit par le « ZnO nanométrique sans traitement de surface », et ce malgré une température de mélange abaissée à 200°C.

Ces mélanges ne seront donc pas pressés ni analysés en termes de propriétés optiques.

### Mesures optiques :

L'absorbance et la transmittance de ces films sont mesurées sur un spectrophotomètre CARY 300 de VARIAN muni d'une sphère d'intégration (avec un angle de 8°): Le porte-film est installé à l'entrée de la sphère et le Spectralon est mis sur le porte échantillon réflectance. La ligne de base est enregistrée avec le porte-film vide. Les spectres UV des films sont obtenus avec les paramètres suivants :
- module spectres
- gamme : 200-800 nm
- vitesse :12 nm/min
- changement de lampe : 350 nm
- mode : Transmittance
- SBW : 2.0 nm

Il a été choisi de comparer les valeurs d'Absorbance à 340 nm (longueur d'onde correspondant à un minimum d'absorbance dans la zone UV pour les mélanges avec ZnO nanométrique). La valeur d'absorbance mesurée à été ramenée à une épaisseur théorique de film de 50µm par une règle de 3 sur l'épaisseur, afin de faciliter les comparaisons et puisque l'absorbance varie de façon linéaire avec l'épaisseur.

La comparaison de la Transmittance est faite à 450 nm pour tous les mélanges.

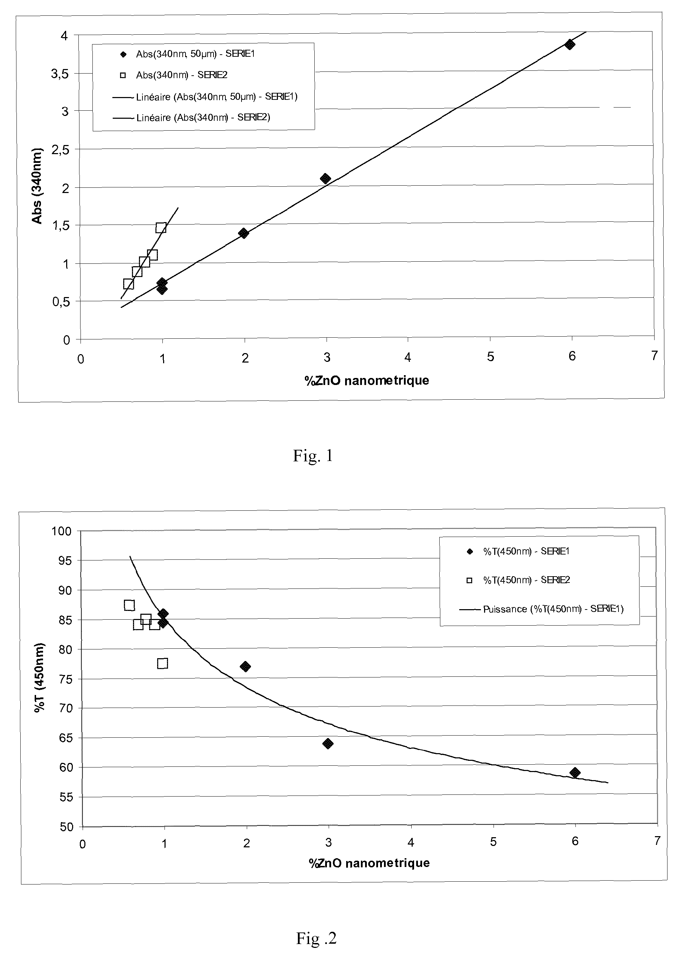

Les résultats sont indiqués dans le tableau 1 ci-dessous et dans les figures 1 et 2 annexées.

**Tableau 1**

| **SERIE1 : Mélanges sur calandre, puis pressage** | | | | | |
|---|---|---|---|---|---|
| Exemple | Traitement de surface sur ZnO nanometrique | %ZnO nanometrique | epaisseur du film (µm) | Abs(340nm, 50µm)-SERIE1 | %T(450nm)-SERIE1 |
| S1-A | oui | 1 | 60 | 0,73 | 84,3 |
| S1-B | oui | 1 | 61 | 0,65 | 85,9 |
| S1-C | oui | 2 | 73 | 1,37 | 76,8 |
| S1-D | oui | 3 | 74 | 2,09 | 63,7 |
| S1-E | oui | 6 | 47 | 3,83 | 58,5 |
| S1-F | non | 1 | début dégradation | | |
| S1-G | non | 1 | début dégradation | | |

### SERIE-2 : mélanges sur extrudeuse puis extrusion d'un film

Un mélange-maître à 7,5% de « ZnO nanométrique avec traitement de surface » (Zano20) dans du Kynar 1000HD (PVDF homopolymère) a été réalisé sur une extrudeuse bi-vis co-rotative (diamètre 27mm, L./D=44) dans les conditions suivantes : alimentation de la charge en zone fondue, température de consigne de 230°C, vitesse de vis de 250 tour/min, débit de 20kg/h. On obtient un jonc blanc et lisse qui est ensuite granulé. Les granulés peuvent présenter une bulle de retrait au centre mais sont exempts de fines bulles de dégradation.

Ce mélange-maître est ensuite incorporé dans du Kynar 1000HD ou Kynarflex 3120-50 par mélange à sec de granulés, pour donner respectivement les mélanges S2-A (dans Kynar 1000HD) et S2-B à S2-F (dans Kynarflex 3120-50). Le taux d'incorporation du mélange-maître définit le taux de « ZnO nanométrique avec traitement de surface » (Zano20) dans le mélange final tel qu'indiqué dans le tableau ci-dessous. Le Kynarflex 3120-50 est un copolymère VDF-HFP.

Ces mélanges de granulés sont alors extrudés sur une extrudeuse monovis de film en soufflage de gaine (diamètre vis 30 mm, L./D=25, diamètre filière 50mm, entrefer 1,2 mm) dans les conditions suivantes : température 250°C, vitesse de tirage 5,4 m/min, BUR 2,55.

Les films obtenus ont une épaisseur proche de 50µm et sont analysés en termes d'absorbance et transmittance de la même façon que les mélanges de la SERIE-1 précédente. Les valeurs d'absorbances sont les valeurs lues et non rapportées à une épaisseur théorique de 50µm comme pour la SERIE-1. Les résultats sont reportés dans le tableau 2 ci-dessous et dans les figures 1 et 2 annexées.

**Tableau 2**

| **SERIE2** : **Mélanges sur extrudeuse, puis extrusion d'un film** | | | | | |
|---|---|---|---|---|---|
| Exemple | Traitement de surface sur ZnO nanometrique | %ZnO nanometrique | Matrice Kynar | Abs(340nm) - SERIE2 | %T(450nm)SERIE2 |
| S2-A | oui | 1 | 1000HD | 1,34 | 72,2 |
| S2-B | oui | 1 | 3120-50 | 1,46 | 77,4 |
| S2-C | oui | 0,9 | 3120-50 | 1,1 | 84 |
| S2-D | oui | 0,8 | 3120-50 | 1,01 | 85 |
| S2-E | oui | 0,7 | 3120-50 | 0,88 | 84 |
| S2-F | oui | 0,6 | 3120-50 | 0,72 | 87,3 |

## Revendications

1. Procédé de préparation d'une composition comprenant un polymère ou copolymère de fluorure de vinylidène (PVDF) et au moins une charge inorganique, ledit procédé comprenant les étapes suivantes :
i) préparer un mélange maître acrylique en dispersant ladite charge inorganique dans un polymère ou copolymère de méthacrylate de méthyle (PMMA), et
ii) mélanger ledit mélange maître avec le PVDF à l'état fondu.

2. Procédé selon la revendication 1 dans lequel ladite charge inorganique est choisie parmi le TiO₂, SiO₂, CaO, MgO, CaCO₃, et Al₂O₃.

3. Procédé selon l'une des revendications 1 et 2 dans lequel le PVDF est un homopolymère de fluorure de vinylidène.

4. Procédé selon l'une des revendications 1 et 2 dans lequel le PVDF est un copolymère de fluorure de vinylidène (VDF) et d'au moins un autre monomère fluoré, ledit copolymère comprenant au moins 50% en poids de VDF.

5. Procédé selon la revendication 4 dans lequel l'autre monomère fluoré est l' hexafluoropropène.

6. Film monocouche opaque aux radiations UV et transparent dans le domaine visible, consistant en la composition selon l'une des revendications 1 à 5.

7. Panneau photovoltaïque dans lequel la face avant et/ou la face arrière est constituée du film selon la revendication 6.
